**Europäisches Patentamt**

(19) **European Patent Office**

**Office européen des brevets**

(11) Veröffentlichungsnummer: **0 156 930 B1**

(12) **EUROPÄISCHE PATENTSCHRIFT**

(45) Veröffentlichungstag der Patentschrift: **24.06.87**

(21) Anmeldenummer: **84103592.6**

(22) Anmeldetag: **31.03.84**

(51) Int. Cl.⁴: **B 60 R 21/32,** B 60 R 22/40, B 60 R 22/46 // G01P15/00, H03K5/04

(54) **Schaltungsanordnung, insbesondere für ein Rückhaltesystem in Kraftfahrzeugen.**

(43) Veröffentlichungstag der Anmeldung:
**09.10.85 Patentblatt 85/41**

(45) Bekanntmachung des Hinweises auf die Patenterteilung:
**24.06.87 Patentblatt 87/26**

(84) Benannte Vertragsstaaten:
**AT CH DE FR GB IT LI SE**

(56) Entgegenhaltungen:
**FR - A - 2 522 302**

**RADIO FERNSEHEN ELEKTRONIK, Band 30, Nr. 5, 1981, Seite 328, Berlin, DD; G. TURINSKY: "Schaltungen zur Veränderung der Impulsdauer"**

(73) Patentinhaber: **ROBERT BOSCH GMBH, Postfach 50, D-7000 Stuttgart 1 (DE)**

(72) Erfinder: **Mattes, Bernhard, Dipl.-Ing., Querstrasse 41, D-7123 Sachsenheim 1 (DE)**
Erfinder: **Oswald, Klaus, Dipl.-Ing., Schäfersteige 23, D-7306 Denkendorf (DE)**
Erfinder: **Suchowerskyj, Wadym, Dr. Dipl.-Ing., Holdergasse 26, D-7141 Schwieberdingen (DE)**

EP 0 156 930 B1

**Beschreibung**

Die Erfindung geht aus von einer Schaltungsanordnung, insbesondere für ein Rückhaltesystem an Kraftfahrzeugen, nach dem Oberbegriff des Hauptanspruches.

Aus der DE-A-2 151 399 ist bereits eine stossempfindliche Anordnung, insbesondere für ein Rückhaltesystem in Kraftfahrzeugen, mit wenigstens einem piezoelektrischen Kristall als mechanisch-elektrischem Umformer bekannt, wobei an den mechanisch-elektrischen Umformer ein Spannungsbegrenzer, an diesen ein Integrator und an jenen eine Schwellwertschaltung angeschlossen ist. Diese stossempfindliche Anordnung kann als Auslösevorrichtung für, dem Schutz von Fahrgästen eines Kraftfahrzeuges dienender Einrichtungen wie aufblasbare Schutzkissen (Airbag) oder Gurtstraffer angeschlossen sein. Bei einem Stoss der am mechanisch-elektrischen Umformer ein Signal verursacht, ist es möglich, dass das Ausgangssignal des Integrators die Schwellwertschaltung nur sehr kurzfristig erregt, so dass die Schwellwertschaltung einen sehr kurzen Ausgangsimpuls liefert. Damit ist die Gefahr gegeben, dass eine Auslösung des aufblasbaren Schutzkissens oder der Gurtstraffer, etwa durch Zündung von Zündpillen, nicht sicher gewährleistet ist.

Hierzu ist es bekannt, die Schwellwertschaltung in der Art eines Schmitt-Triggers mit einer Hysterese auszugestalten. Da jedoch keine Beeinflussung des Integrators gegeben ist, lassen sich nicht immer ausreichend grosse minimale Ansprechzeiten der Schwellwertschaltung, d.h. minimale Zeitdauern des Ausgangsimpulses der Schwellwertschaltung, erreichen.

Aus der FR-A-2 522 302 ist ebenfalls eine gattungsgleiche Schaltungsanordnung bekannt, die neben einer Integratorschaltung auch eine Schwellwertschaltung nach Art eines Schmitt-Triggers mit Hysteresecharakteristik umfasst. Die Schwellwertschaltung besteht aus einem Operationsverstärker mit Rückkopplung. Auch bei dieser Schaltungsanordnung ist wie bei der zuvor erwähnten bekannten Schaltungsanordnung keine Beeinflussung der Integratorschaltung vorgesehen, so dass auch für die zweite Schaltungsanordnung die bereits genannten Nachteile zutreffen.

Der Erfindung liegt die Aufgabe zugrunde, eine verbesserte Schaltungsanordnung anzugeben, die auch bei kurzen, für eine Gefahrensituation charakteristischen Eingangsimpulsen eine sichere Auslösung des Rückhaltesystems gewährleistet.

Ausgehend von einer Schaltungsanordnung der eingangs näher bezeichneten Art wird diese Aufgabe durch die im kennzeichnenden Teil des Anspruches 1 genannten Merkmale gelöst.

Vorteilhafte Ausgestaltungen dieser Schaltungsanordnung gehen aus den Unteransprüchen hervor.

Die vorgeschlagene Schaltungsanordnung bietet den Vorteil, dass durch die minimale Ansprechzeit der Schwellwertschaltung auch bei kurzen Eingangsimpulsen ein sicheres Ansprechen der erfindungsgemässen Schaltung erreicht wird und dadurch eine sichere Auslösung des Rückhaltesystems bei Gefahrensituationen gewährleistet ist.

In den Unteransprüchen sind vorteilhafte Ausgestaltungen der Erfindung angegeben.

Bei einem Integrator, der einen Referenzwert als Ansprechschwelle besitzt, ist es möglich, durch ein Rückkoppelnetzwerk diesen Referenzwert so zu beeinflussen, dass das Eingangssignal für eine minimale Zeit über dem Referenzwert des Integrators zu liegen kommt, wenn eine Bandbegrenzung des Eingangssignals gegeben ist. Das Rückkopplungsnetzwerk erkennt hierfür eine Flanke des Ausgangssignals des Schwellwertschalters durch Differentiation und führt ein so gewonnenes differenziertes Signal an die Referenzwertbildung des Integrators zurück. Vorteilhaft sind weiter Mittel, die eine Differentiation nur bei einer Flankeneinrichtung erlauben, damit keine Referenzwertbeeinflussung durch die hintere Flanke des Ausgangsimpulses des Schwellwertschalters möglich ist.

Ein Ausführungsbeispiel der Erfindung ist in der Zeichnung dargestellt und in der nachfolgenden Beschreibung näher erläutert.

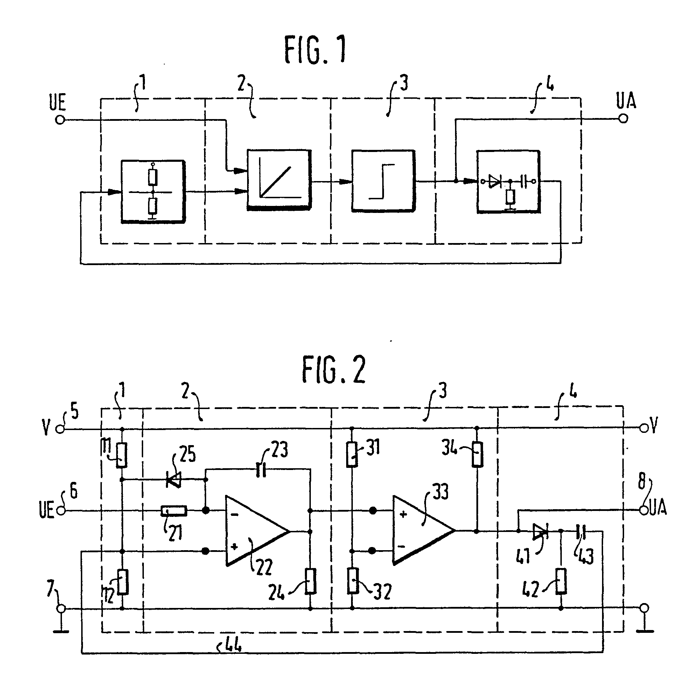

Fig. 1 zeigt ein Blockschaltbild, Fig. 2 eine detaillierte schaltungstechnische Ausgestaltung.

Fig. 1 zeigt einen Integrator 2, dem ein Eingangssignal $U_E$ zur Integration zugeführt wird, und eine Referenzwertbildung 1, die einen Referenzwert als Ansprechschwelle ebenfalls dem Integrator 2 zuführt. Das Eingangssignal $U_E$ ist ein Signal, das von einem mechanisch-elektrischen Umformer abgeleitet wurde. Zur Vereinfachung der Darstellung ist dieser jedoch nicht weiter gezeigt. Das Ausgangssignal des Integrators 2 wird auf einen Schwellwertschalter 3 geführt, der dann einen Impuls abgibt, wenn das Ausgangssignal des Integrators 2 den Schwellwert des Schwellwertschalters 3 übersteigt. Das Ausgangssignal des Schwellwertschalters 3 ist gleichzeitig das Ausgangssignal $U_A$ der erfindungsgemässen Schaltungsanordnung.

Über ein Rückkopplungsnetzwerk 4 wird eine Beeinflussung der Referenzwertbildung 1 durchgeführt, so dass sich eine minimale Ansprechzeit des Schwellwertschalters 3 ergibt. In Fig. 2 ist eine detaillierte schaltungstechnische Ausführung des in Fig. 1 gezeigten Blockdiagramms angegeben. Das Eingangssignal $U_E$ ist an eine Eingangsklemme 6 gelegt. Der Integrator 2 wird durch einen Differenzverstärker 22 gebildet, der mit einem Integrationskondensator 23, einem Integrationswiderstand 21 und einem Ausgangswiderstand 24 beschaltet ist. Die Schaltung ist dabei zwischen einer Versorgungsspannungsklemme 5 und einem Massepotential 7 aufgebaut, wobei zur Vereinfachung der Darstellung Versorgungsleitungen und Kompensationsbeschaltungen des Differenzverstärkers 22 nicht gezeigt sind. Die Referenzwertbildung 1 wird durch einen Widerstandsspannungsteiler, bestehend aus zwei Widerständen 11 und 12 am Plus-Eingang des Differenzverstärkers 22 gebildet. Eine in Flussrichtung vom Minus-Eingang des Differenzverstärkers 22 zum Verbindungspunkt der Widerstände 11, 12 geschaltete Diode 25 begrenzt die Aufladung des Integrationskondensators 23 bei grosser positiver Eingangsspannung $U_E$. Das Ausgangssignal des Integrators 2 führt auf den Plus-Eingang eines Differenzverstärkers, der mit einer Schwelleinstellung, bestehend aus zwei Widerständen 31, 32 am Minus-Eingang und einem Ausgangswiderstand 34 beschaltet ist. Der Ausgang des Differenzverstärkers 33 führt auf eine Ausgangsklemme 8. Das Rückkopplungsnetzwerk 4 ist ausgeführt durch eine Diode 41, die in Flussrichtung über einen Widerstand 42 gegen Masse gepolt ist. Ein Kondensator 43 differenziert die Spannung, die am Widerstand 42 anliegt, und bildet über eine Rückkopplungsleitung 44 eine Referenzwertbeeinflussung am Verbindungspunkt der Widerstände 11 und 12.

Zu Beginn sei das Eingangssignal $U_E$ an das Potential am Plus-Eingang des Differenzverstärkers 22 gelegt. Dann ist der Integrationskondensator 23 so geladen, dass der Ausgang des Differenzverstärkers 22 an Masse liegt, der Ausgang des Differenzverstärkers 33 liegt dann ebenfalls an Masse.

Unterschreitet nun durch einen Stoss, der am nicht dargestellten mechanisch-elektrischen Umwandler ein Signal erzeugt, das Eingangssignal $U_E$ den Referenzwert des Integrators 2, so fliesst ein Strom in den Integrationskondensator 23, wodurch sich dieser umlädt und sich das Potential des Ausgangs des Differenzverstärkers 22 anhebt. Wird nun die Schwelle des Schwellwertschalters 3 überschritten, so erscheint eine positive Signalflanke am Ausgang des Differenzverstärkers 33. Diese positive Signalflanke führt über die Diode 41 zu einem Spannungsabfall am Widerstand 42, der über den Kondensator 43 differenziert wird, wodurch ein zusätzlicher Strom vom Kondensator 43 in den Spannungsteiler der Widerstände 11, 12 der Referenzwertbildung 1 fliesst. Dieser zusätzliche Strom führt zu einer Anhebung des Referenzwertes des Integrators 2, wodurch die Zeitspanne vergrössert wird, in der das Eingangssignal $U_E$ den Referenzwert unterschreitet. Somit wird eine minimale Ansprechzeit des Schwellwertschalters 3 erreicht. Eine zusätzliche Vergrösserung der Sicherheit der erfindungsgemässen Schaltungsanordnung lässt sich noch dadurch erreichen, dass der Schwellwertschalter 3 mit einer Hysterese versehen wird.

Die erfindungsgemässe Schaltungsanordnung ist nicht nur für Rückhaltesysteme in Kraftfahrzeugen geeignet. Sie ist überall dort einsetzbar, wo ein durch die Schaltungsanordnung angesteuertes System eine minimale Ansteuerzeit, etwa aus Sicherheitsgründen, benötigt, wie z.B. bei Lasten mit grosser Eingangskapazität, Relais und Stromversorgungen.

**Patentansprüche**

1. Schaltungsanordnung, insbesondere für ein Rückhaltesystem in Kraftfahrzeugen, mit einem Integrator (2), an den ein Schwellwertschalter (3) angeschlossen ist, der einen rückgekoppelten Operationsverstärker umfasst, dadurch gekennzeichnet, dass dem Integrator (2) durch einen Spannungsteiler (R 11, R 12) ein Spannungsreferenzwert vorgegeben ist, und dass am Ausgang des Schwellwertschalters (3) Schaltungsmittel (4, 41, 42, 43) vorgesehen sind, die das Ausgangssignal des Schwellwertschalters (3) differenzieren und das differenzierte Signal zwecks Verschiebung des Referenzwertes dem Eingang des Integrators (2) zuführen.

2. Schaltungsanordnung nach Anspruch 1, dadurch gekennzeichnet, dass Schaltungsmittel einen Widerstand (42) und einen Kondensator (43) umfassen, wobei der Widerstand (42) einseitig an Masse liegt, dass das freie Ende des Kondensators (43) mit einer Rückkopplungsleitung (44) verbunden ist und das Ausgangssignal des Schwellwertschalters (3) an den gemeinsamen Verbindungspunkt des Widerstands (42) und des Kondensators (43) geführt ist.

3. Schaltungsanordnung nach einem der Ansprüche 1 und 2, dadurch gekennzeichnet, dass zwischen dem Ausgangsanschluss des Schwellwertschalters (3) und dem Verbindungspunkt zwischen Widerstand (42) und Kondensator (43) eine Diode (41) eingeschaltet ist.

**Claims**

1. Circuit arrangement, particularly for a retention system in motor vehicles, comprising an integrator (2) which is connected to a threshold switch (3) comprising an operational amplifier with feedback, characterized in that the integrator (2) is supplied with a voltage reference value by means of a voltage divider (R 11, R 12) and that at the output of the threshold switch (3), circuit means (4, 41, 42, 43) are provided which differentiate the output signal of the threshold switch (3) and feed the differential signal to the input of the integrator (2) for the purpose of displacing the reference value.

2. Circuit arrangement according to Claim 1, characterized in that the circuit means comprise a resistor (42) and a capacitor (43), in which arrangement the resistor (42) is connected to earth on one side, that the free end of the capacitor (43) is connected to a feedback line (44) and the output signal of the threshold switch (3) is conducted to the common connecting point between the resistor (42) and the capacitor (43).

3. Circuit arrangement according to one of Claims 1 and 2, characterized in that a diode (41) is inserted between the output connection of the threshold switch (3) and the connection point between resistor (42) and capacitor (43).

**Revendications**

1. Dispositif de circuit, notamment pour un système de retenue dans des véhicules automobiles avec un intégrateur (2) auquel est raccordée un commutateur à valeur de seuil (3), qui comprend un amplificateur opérationnel couplé en réaction, dispositif caractérisé en ce qu'une valeur de référence de tension est préalablement fournie à l'intégrateur (2) par un diviseur de tension (R 11, R 12) et qu'à la sortie du commutateur à valeur de seuil (3) il est prévu des moyens de commutation (4, 41, 42, 43) qui différencient le signal de sortie de ce commutateur à valeur de seuil (3) et qui appliquent à l'entrée de l'intégrateur (2) ce signal différencié en vue de décaler la valeur de référence.

2. Dispositif de circuit selon la revendication 1, caractérisé en ce que les moyens de commutation comprennent une résistance (42) et un condensateur (43), la résistance (42) étant d'un côté à la masse, l'extrémité libre du condensateur (43) étant reliée à une liaison (44) de couplage en réaction, et le signal de sortie du commutateur à valeur de seuil (3) étant appliqué au point de jonction commun de la résistance (42) et du condensateur (43).

3. Dispositif de circuit selon une des revendications 1 et 2, caractérisé en ce qu'entre le raccordement de sortie du commutateur à valeur de seuil (3) et le point de jonction entre la résistance (42) et le condensateur (43) est insérée une diode (41).

# FIG. 1

# FIG. 2